(19) Europäisches Patentamt
European Patent Office
Office européen des brevets

(11) **EP 2 073 210 B1**

(12) **FASCICULE DE BREVET EUROPEEN**

(45) Date de publication et mention de la délivrance du brevet:
**07.05.2014 Bulletin 2014/19**

(51) Int Cl.:
***G11C 11/16*** *(2006.01)*

(21) Numéro de dépôt: **08305936.0**

(22) Date de dépôt: **15.12.2008**

(54) **Mémoire magnétique à écriture assistée thermiquement**

Magnetspeicher zum wärmeunterstützten Schreiben

Magnetic memory with heat-assisted writing

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **21.12.2007 FR 0760303**

(43) Date de publication de la demande:
**24.06.2009 Bulletin 2009/26**

(73) Titulaire: **Commissariat à l'Énergie Atomique et aux Énergies Alternatives 75015 Paris (FR)**

(72) Inventeur: **Redon, Olivier 38170 Seyssinet-Pariset (FR)**

(74) Mandataire: **Vuillermoz, Bruno et al Cabinet Laurent & Charras "Le Contemporain" 50, Chemin de la Bruyère 69574 Dardilly Cédex (FR)**

(56) Documents cités:
**EP-A- 1 653 516          US-A- 5 953 248 US-A1- 2005 002 230**

EP 2 073 210 B1

**Description**

**DOMAINE DE L'INVENTION**

La présente invention se rattache au domaine technique des mémoires magnétiques, et plus particulièrement aux mémoires magnétiques à accès aléatoire non volatiles, permettant de manière connue, le stockage, la lecture et l'écriture de données dans les systèmes électroniques.

L'invention concerne également un procédé d'écriture thermomagnétique dans un tel dispositif.

L'invention trouve son application en électronique et plus particulièrement dans la réalisation de points mémoire pour des mémoires de type MRAM (pour l'acronyme *« Magnetic Random Access Memory »* ou mémoire magnétique à accès direct.

**ETAT ANTERIEUR DE LA TECHNIQUE**

Les mémoires magnétiques MRAM ont connu un regain d'intérêt avec la mise au point de jonctions tunnel magnétiques (JTM) présentant une forte magnétorésistance à température ambiante. Ces mémoires magnétiques à accès aléatoire présentent en effet de nombreux atouts :

- rapidité proche de celle des SRAM (quelques nanosecondes de durée d'écriture et de lecture),
- densité proche de celle des DRAM,
- non volatilité, comme les mémoires flash,
- absence de fatigue à la lecture et à l'écriture,
- insensibilité aux radiations ionisantes, problème de plus en plus aigu en raison de la réduction des dimensions des transistors élémentaires.

Ce faisant, elles sont susceptibles de remplacer les différentes mémoires de technologie plus traditionnelle en combinant les meilleures propriétés de chacune, et ainsi devenir une mémoire universelle.

Les premières mémoires magnétiques réalisées étaient constituées d'un ensemble de points mémoire ou cellules mémoire, comprenant chacun un élément dit « à magnétorésistance géante », formé d'un empilement de plusieurs couches métalliques alternativement magnétiques et non magnétiques.

On a par exemple décrit ce type de structure dans les documents US 4 949 039 et US 5 159 513 pour les structures de base, et dans le document US 5 343 422 pour la réalisation d'une mémoire RAM à partir de telles structures de base.

Cette technologie, de par son architecture, permet la réalisation de mémoires non volatiles avec une technologie simple, mais cependant de capacité limitée. En effet, le fait que les éléments mémoire ou points mémoire soient connectés en série le long de chaque ligne, limite la possibilité d'intégration, puisque le signal est de plus en plus faible lorsque le nombre d'éléments ou points mémoire augmente.

La mise au point des points mémoire à jonction tunnel magnétique JTM a permis une augmentation significative des performances et du mode de fonctionnement de ces mémoires. De telles mémoires magnétiques à jonction tunnel magnétique ont par exemple été décrites dans le document US-A-5 640 343. Dans leurs formes les plus simples, elles sont composées de deux couches magnétiques de coercitivités différentes, séparées par une couche mince isolante.

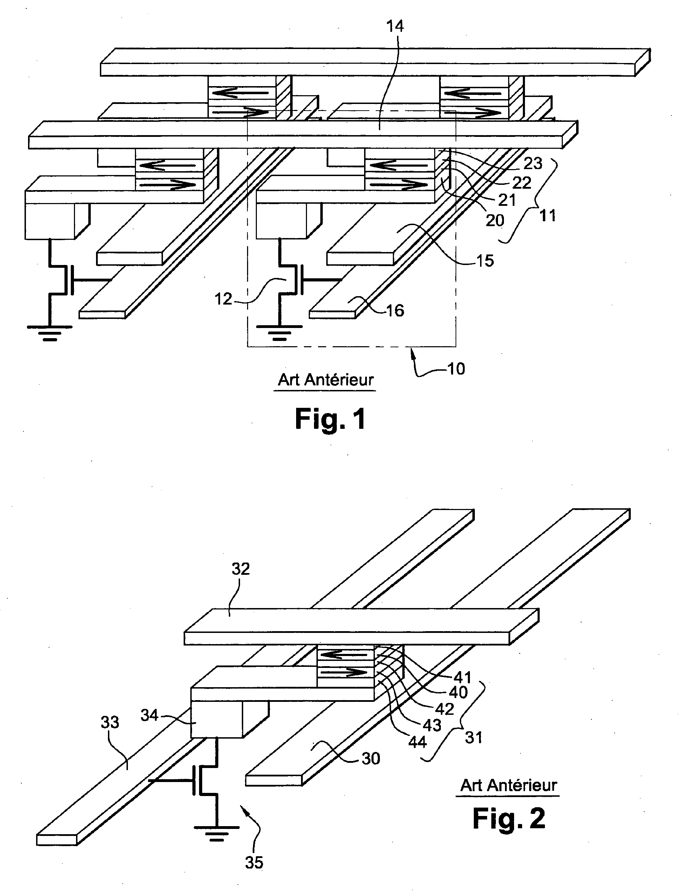

Les premiers modes d'écriture proposés pour ce type de mémoire étaient basés sur un renversement de l'aimantation d'une des deux couches magnétiques, par superposition de deux champs magnétiques orthogonaux. Les écritures de type STONER-WOLFARTH sont mises en oeuvre dans la famille des "FIMS" (acronyme de l'expression anglo-saxonne *"Field Induced Magnetic Switching"* - c'est-à-dire renversement de l'aimantation par un champ magnétique induit), et par exemple décrites dans le document US-A-6 021 065 et dans la publication *"Journal of Applied Physics"* vol. 81, 1997, page 3758. Selon cette architecture, la cellule mémoire doit permettre de produire deux champs magnétiques orthogonaux. La figure 1 illustre une telle architecture pour une écriture du type STONER-WOLFARTH.

Comme on peut l'observer sur cette figure, chaque élément mémoire ou point mémoire (10) est constitué de l'association d'un transistor de technologie CMOS (12) et d'une jonction tunnel magnétique JTM (11). Ladite jonction tunnel (11) comporte au moins une couche magnétique (20), dite « couche de stockage » ou « couche libre », une fine couche isolante (21), et une couche magnétique (22) dite « couche piégée », également dénommée « couche de référence ».

Préférentiellement, mais cependant de manière non limitative, les deux couches magnétiques sont réalisées à base de métaux 3d (Fe, Co, Ni) et leurs alliages, et la couche isolante est traditionnellement constituée d'alumine ($Al_2O_3$), voire d'oxyde de magnésium (MgO). Avantageusement, la couche magnétique (22) est couplée à une couche anti-ferromagnétique (23), dont la fonction est de piéger la couche (22), afin que son aimantation ne bascule pas lors des phases d'écriture.

Avantageusement, la couche piégée (22) peut elle-même être constituée de plusieurs couches comme par exemple décrit dans le document US-A-5 583 725, et ce afin de constituer une couche dite « anti-ferromagnétique synthétique » (SAF).

Le fonctionnement de ces cellules magnétiques, constituées chacune d'une jonction tunnel magnétique, consiste, notamment pour l'écriture, à générer deux champs magnétiques impulsionnels créés par des lignes de courant ou conducteurs associées à chacun desdites jonction tunnel.

Ainsi, et dans le cadre de l'architecture de type FIMS, on observe trois niveaux de ligne d'adressage. Dans la figure 1, les deux niveaux de ligne (14) (*bit line*) et (15) *(digit line),* généralement disposés à 90° l'un de l'autre, sont donc destinés à générer des impulsions de champ magnétique permettant la commutation de l'aimantation de la couche libre (20) lors du processus d'écriture. Ces impulsions de champ magnétique sont produites en faisant circuler dans les lignes de courant (14) et (15), des impulsions électriques courtes, typiquement 2 à 50 nanosecondes, et d'intensité de l'ordre de quelques milliampères. L'intensité de ces impulsions et leur synchronisation sont ajustées, de sorte que seule l'aimantation du point mémoire situé à la croisée de ces deux lignes de courant est susceptible de commuter.

Un niveau de ligne d'adressage additionnel (16), également dénommé *"word line"* est destiné à commander l'ouverture ou la fermeture du canal des transistors de sélection ou de commutation (12) associé à chaque point mémoire, afin de pouvoir adresser en lecture chaque élément mémoire individuellement. En d'autres termes, les transistors (12) CMOS sont utilisés comme des interrupteurs.

En mode écriture du point mémoire considéré, le transistor (12) sélectionné est en mode bloqué ou OFF, aucun courant ne traverse donc le transistor. On envoie une impulsion de courant I dans les deux lignes de courant (14) et (15) correspondant au point mémoire (10) sélectionné. L'amplitude de l'impulsion de courant I est telle que le champ magnétique créé ne soit pas suffisant pour faire basculer les points mémoire sur les lignes (14) ou (15), sauf à l'intersection des lignes (14) et (15) où la contribution conjointe des deux lignes est suffisante pour générer un champ magnétique susceptible de faire basculer l'aimantation de la couche (20) du point mémoire considéré.

En mode lecture, le transistor (12) est en mode saturé ou ON par l'envoi d'une impulsion de tension positive dans la grille dudit transistor à travers la ligne de commande (16). Un courant de mesure est ensuite envoyé dans la ligne de courant (14) qui ne peut traverser que le seul point mémoire dont le transistor (12) est placé en mode saturé ou ON. Par ce courant, on effectue une mesure de la résistance de la jonction tunnel magnétique (11) dudit point mémoire (10) sélectionné. Par comparaison avec un point mémoire de référence (non représenté), l'état correspondant du point mémoire (10) "0" ou "1" peut alors être déterminé.

On aura compris à la lumière de ce qui précède que l'intensité des impulsions traversant les lignes de courant (14) et (15) et leur synchronisation sont ajustées de telle sorte que seule l'aimantation du point mémoire se trouvant à l'intersection de ces deux lignes de courant (point sélectionné) peut commuter sous l'effet du champ magnétique généré par les deux conducteurs. Les autres points mémoire situés sur la même ligne ou sur la même colonne (points demi-sélectionnés) ne sont de fait assujettis qu'au champ magnétique d'un seul des conducteurs (14, 15), et en conséquence ne se retournent pas.

De par le mécanisme d'écriture de ces points mémoire, on est à même de comprendre les limites de cette architecture. Dans la mesure où l'écriture est assurée par un champ magnétique induit, les intensités de courant sont assujetties à la valeur du champ de retournement individuel de chaque point mémoire. Comme la fonction de distribution des champs de retournement pour l'ensemble des points mémoire est large (en effet, elle n'est pas uniforme en raison des contraintes de fabrication et des fluctuations statistiques intrinsèques), il est nécessaire que le champ magnétique sur le point mémoire sélectionné soit supérieur au champ de retournement le plus élevé de la distribution, au risque de renverser accidentellement certains points mémoire situés sur la ligne ou sur la colonne correspondante, où le champ de retournement, situé dans la partie basse de la distribution est plus faible que le champ magnétique généré par la ligne ou la colonne seule. Au surplus, la consommation électrique de la mémoire mettant en oeuvre un tel champ magnétique extérieur sera d'autant plus importante que la distribution du champ de retournement sera large.

De plus, attendu qu'en général, la valeur moyenne du champ de retournement augmente lorsque la taille des points mémoire diminue, ce que l'on tend à obtenir, un courant d'autant plus important est attendu dans les générations de produits futurs. En conséquence, la puissance électrique requise pour le fonctionnement de ces mémoires sera d'autant plus grande que l'intégration sera poussée.

Un autre inconvénient de ces mémoires de l'état de l'art concerne la stabilité de l'aimantation de la couche libre vis-à-vis des fluctuations thermiques lorsque la taille du point mémoire diminue. En effet, la barrière d'énergie à franchir pour faire commuter l'aimantation de cette couche d'une orientation à l'autre est proportionnelle au volume de cette couche. Lorsque le volume diminue, la hauteur de la barrière devient alors comparable à l'agitation thermique. L'information écrite dans la mémoire n'est alors plus conservée. Pour pallier cette difficulté, on est obligé d'augmenter l'anisotropie magnétique de la couche libre en choisissant un matériau de plus forte anisotropie ou en accentuant l'anisotropie de forme du point mémoire, par exemple. Mais ce faisant, le champ magnétique nécessaire à la commutation magnétique augmente, menant à une consommation électrique accrue pour générer le champ nécessaire à la commutation magnétique. Aussi, on a proposé la mise en oeuvre de mémoires magnétiques à accès aléatoire assistées thermiquement, dénommées selon l'acronyme TA-MRAM (pour « thermally assisted MRAM »), dans laquelle la couche libre est elle-même piégée par une couche anti-ferromagnétique. Ce perfectionnement est par exemple décrit dans le document US 6 385 082.

On a représenté au sein de la figure 2 une cellule mémoire de type TA-MRAM. Dans celle-ci, la couche libre (41) de la jonction tunnel magnétique (31) est piégée par une couche anti-ferromagnétique (40). De même que dans le cas des cellules de type FIMS, une couche isolante (42) est comprise entre la couche libre magnétique (41) et une couche magnétique (43) dite « couche piégée ». Selon cette configuration, les deux couches magnétiques sont avantageusement réalisées en des métaux de transition 3d (Fe, Co, Ni) et leurs alliages, dopées ou non (de bore notamment), et la couche isolante peut être de l'alumine ou de l'oxyde de magnésium. Selon une version avantageuse, la couche magnétique piégée (43) est couplée à une couche anti-ferromagnétique (44), dont la fonction est de piéger la couche (43) afin que son aimantation ne bascule pas lors de l'écriture.

Là encore, la couche de référence (43) peut être une couche anti-ferromagnétique synthétique constituée de plusieurs couches.

Selon cette configuration, la couche anti-ferromagnétique (40) possède une température caractéristique dite « de blocage » $T_B$ au dessus de laquelle le champ magnétique dit « d'échange » stabilisant qu'elle exerce sur la couche libre (41) n'est plus effectif. On sélectionne le matériau constituant la couche anti-ferromagnétique (40) ainsi que son épaisseur, de telle sorte que la température de blocage $T_B$ soit supérieure à la température d'utilisation de la mémoire (température de fonctionnement au repos). De la même manière, on sélectionne la température de blocage $T_B$ de la couche anti-ferromagnétique (40) afin qu'elle soit inférieure et assez éloignée de la température de blocage de la couche anti-ferromagnétique (44) adjacente à la couche piégée (43).

Ainsi, à une température inférieure à la température de blocage de la couche anti-ferromagnétique (40), la couche libre (41) est stabilisée par le champ magnétique d'échange, et ainsi elle s'avère très difficile à retourner par la simple application d'un champ magnétique externe. A la température de blocage de la couche anti-ferromagnétique (40) et au-delà, le champ d'échange étant nul, la couche libre (41) devient alors très facile à retourner par l'intermédiaire d'un champ magnétique externe, à condition que ce dernier soit supérieur au champ coercitif de la couche libre (41) à la température donnée. De fait, on choisit pour la couche libre (41) un matériau permettant à cette dernière d'avoir un champ coercitif faible.

Cette architecture particulière comporte également trois niveaux de ligne d'adressage. Selon cette configuration, la ligne de courant (30) dite « digit line », est située sous la jonction tunnel magnétique (31) sans cependant être en contact avec cette dernière. Elle est destinée à générer le champ magnétique nécessaire au renversement de la couche libre de stockage (41), dès lors qu'un courant électrique de quelques centaines de microampères la traverse. Perpendiculairement à cette digit line (30), est située la bit line (32), située au-dessus de la jonction tunnel magnétique (31) du point mémoire considéré et en contact avec celle-ci. Cette bit line est destinée à amener le courant de chauffage dans la jonction tunnel considérée. Une troisième ligne d'adressage (33) dite « *Word line* » permet de commuter le transistor de sélection (35) en mode ON ou OFF. De même que pour le FIMS, la *word line* commande l'ouverture ou la fermeture du canal des transistors sur toute sa longueur par l'application ou non d'une tension de commande, chacun des transistors fonctionnant en mode interrupteur pour chacun des points mémoire associés.

En mode lecture, le transistor CMOS (35), associé au point mémoire à lire, est fermé par l'application d'une tension adéquate dans la *word line* (33). Le principe de lecture demeure identique à celui décrit en relation avec une cellule de type FIMS.

En mode écriture, le transistor CMOS (35) du point mémoire à écrire est fermé par l'intermédiaire de l'application d'une tension adéquate dans la *word line* (33). Une impulsion de courant de chauffage est alors envoyée dans le point mémoire à écrire par la *bit line* (32). Lorsque la densité de courant j circulant dans la jonction tunnel (31) est suffisante, la densité de puissance générée $P = RA \cdot j^2$ (où RA est le produit de la résistance de la jonction tunnel par sa surface A) permet une élévation de température dans ladite jonction tunnel au dessus de la température de blocage $T_B$ de la couche anti-ferromagnétique (40) en contact avec la couche de stockage (41). Le champ d'échange stabilisant la couche libre (41) devient alors nul, et cette dernière est alors très mobile. Une impulsion électrique de quelques centaines de microampères sur quelques nanosecondes est alors envoyée dans la digit line (30) une fois que la température de blocage est atteinte (au bout de quelques nanosecondes), et génère un champ magnétique suffisant pour retourner dans le sens souhaité (écriture du bit « 1 » ou « 0 »), la couche libre (41), qui comme déjà dit, est à ce moment précis très mobile, avec une coercitivité intrinsèque faible. Une fois que la couche libre (41) a été écrite, on coupe alors le courant de chauffage dans la jonction tunnel magnétique (31) (par coupure du courant dans la *bit line* (32) et ouverture du transistor (35)). La température globale du point mémoire chute alors très rapidement (quelques nanosecondes) en deçà de la température de blocage de la couche anti-ferromagnétique (40) (à la température de fonctionnement au repos typiquement), et le champ d'échange reprend alors sa valeur initiale, stabilisant du coup la couche libre (41). Le courant électrique dans la digit line (30) est à son tour coupé.

Un problème de consommation électrique se retrouve dans bon nombre de mémoires magnétiques à accès aléatoire, en particulier lorsqu'il s'agit de générer le champ magnétique d'écriture à l'aide d'une ou plusieurs lignes de champ, que ce soit pour la FIMS et la TA-MRAM décrites précédemment, ou pour la mémoire « toggle switch » décrite par exemple dans le document US 6 549 906.

Il est connu que l'utilisation d'une couche de stockage couplée à une couche antiferromagnétique permet de réaliser un stockage de l'information multibit.

En effet, avec les jonctions tunnels magnétiques de l'état de l'art, un point mémoire dispose de deux états possibles, correspondant aux deux configurations magnétiques parallèles et antiparallèles, ces dernières correspondant respectivement à des alignements parallèles et antiparallèles de l'aimantation de la couche de stockage par rapport à celle de la couche de référence.

Ces systèmes de type bistable sont obtenus en conférant à la couche de stockage une anisotropie magnétique d'origine magnétocristalline ou de forme (points mémoire, par exemple de forme elliptique), avec un axe de facile aimantation parallèle à l'aimantation de la couche de référence. Pour orienter l'aimantation de la couche de stockage dans n'importe quelle direction intermédiaire entre la direction parallèle et la direction antiparallèle à l'aimantation de la couche de référence, on échauffe la couche de stockage et la couche antiferromagnétique adjacente au dessus de la température de blocage en envoyant une impulsion de courant à travers la jonction tunnel magnétique, puis on oriente l'aimantation de la couche de stockage dans la direction désirée au cours du refroidissement de la couche antiferromagnétique. Afin d'obtenir l'orientation désirée pour l'aimantation de la couche de stockage, on applique un champ magnétique local à cette dernière dans la direction désirée. A cet effet, la commutation magnétique est réalisée en envoyant des impulsions de courant dans des lignes conductrices perpendiculaires respectivement situées au dessus et au dessous du point mémoire considéré. Ce faisant, on peut générer des champs magnétiques suivant deux directions perpendiculaires et, en jouant sur l'intensité relative du courant circulant dans les deux lignes de courant, on peut générer un champ magnétique dans n'importe quelle direction du plan, et préférentiellement, selon quatre directions orientées respectivement par rapport à l'orientation de l'aimantation de la couche de référence à 0°, 70°, 110° et 180°, dans l'objectif d'optimiser les différences de résistance entre ces quatre états.

Le document US 2005/000 2230, sur lequel est basé le préambule, décrit une mémoire magnétique dont les points mémoires sont constitués d'une double jonctions tunnel magnétique, lesdites jonctions étant séparées l'une de l'autre par un couche.

Un premier objectif de la présente invention est de proposer un nouveau mode d'écriture thermomagnétique pour les TA-MRAM multibit.

Un second objectif de l'invention est de proposer une cellule TA-MRAM à quatre états en utilisant une seule ligne de champ, et donc mettant en oeuvre une architecture identique à celle décrite en relation avec la figure 2.

Un troisième objectif de l'invention est de proposer une cellule TA-MRAM multibit à faible consommation grâce à la production d'un seul champ magnétique.

Un quatrième objectif de l'invention est de proposer une cellule TA-MRAM multibit présentant une endurance améliorée.

Un cinquième objectif de l'invention est de proposer une architecture matricielle TA-MRAM multibit à une seule ligne de champ, où les quatre états peuvent s'écrire en seulement deux phases d'écriture.

## EXPOSE DE L'INVENTION

Cette mémoire magnétique à écriture assistée thermiquement est constituée de points mémoire ou cellules mémoire, chacun constitué d'une double jonction tunnel magnétique séparée l'une de l'autre par une couche en un matériau antiferromagnétique, et dont l'ordre d'empilement des couches qui les constituent est inversé l'une par rapport à l'autre, chacune des jonctions tunnel magnétique comprenant :

- une couche magnétique de référence, dite « couche piégée », dont l'aimantation est de direction fixe ;
- une couche magnétique de stockage, dite « couche libre », dont la direction de l'aimantation est variable, et constituée d'une couche réalisée en un matériau ferromagnétique à aimantation dans le plan de la couche, couplée magnétiquement par échange avec une couche de piégeage réalisée en un matériau antiferromagnétique et constituée par la couche de séparation des deux jonctions tunnel magnétique ;
- une couche isolante interposée entre la couche de référence et la couche de stockage, constituant la barrière tunnel de la jonction tunnel magnétique considérée.

Selon l'invention :

- la température de blocage de la couche de piégeage antiferromagnétique séparant les deux jonctions tunnel magnétique est inférieure à la température de blocage de la couche de référence de la jonction tunnel magnétique correspondante ;
- le produit RA (résistance x surface) des deux barrières tunnel est différent ;

- chaque point mémoire comprend des moyens d'échauffement des couches de stockage à une température supérieure à la température de blocage desdites couches ;
- la mémoire comprend des moyens d'application d'un champ magnétique aptes à orienter l'aimantation de la couche de stockage ou des couches de stockage de chaque point mémoire par rapport à l'aimantation de la couche de référence ou des couches de référence sans modifier l'orientation des couches de référence considérées ;
- les couches de stockage sont couplées magnéto-statiquement à travers la couche réalisée en matériau antiferromagnétique séparant lesdites couches de stockage, de telle façon que les aimantations de ces dernières se placent dans une configuration antiparallèle lorsque la température dans la jonction tunnel magnétique concernée excède la température de blocage de ladite couche en matériau antiferromagnétique et en l'absence de champ magnétique appliquée à ladite mémoire, ou sous l'influence d'un champ magnétique d'intensité inférieure au couplage magnétostatique entre lesdites couches de stockage.

Ainsi donc et à l'aide d'une telle structure, il est possible de jouer sur la double combinaison du chauffage du point mémoire d'une part et de l'orientation d'un champ magnétique d'autre part pour aboutir à quatre états stables du point mémoire considéré et ce, selon un encombrement réduit.

Avantageusement, le produit RA de l'une des deux barrières tunnel est sensiblement égal à la moitié de l'autre. Ce faisant, on optimise la séparation à la lecture des différents états stables du point mémoire considéré.

Selon une autre caractéristique de l'invention, les moyens pour faire varier l'orientation de l'aimantation des couches de stockage sont constitués d'une seule ligne conducteur, située au dessus ou au dessous du point mémoire magnétique considéré. Ce faisant, on simplifie l'architecture de la mémoire magnétique mettant en oeuvre de tels points mémoire.

En pratique, les points mémoire peuvent être de section transversale elliptique et avantageusement circulaire.

En pratique, les couches de stockage sont constituées à base d'un alliage de Fe, Co, Ni (CoFe ou NiFe), susceptible d'être dopé avec du Bore, notamment lorsque les barrières tunnel sont réalisées en MgO.

De plus, les deux couches de stockage sont couplées magnéto-statiquement à travers la couche de piégeage en matériau antiferromagnétique qui les sépare. Ce couplage magnétostatique oriente préférentiellement les aimantations des couches de stockage de manière antiparallèle, afin de minimiser l'énergie du système. Afin de contrôler les aimantations des couches de stockage, les épaisseurs desdites couches sont différentes.

Selon l'invention, l'aimantation de chacune des couches de stockage et de référence est sensiblement parallèle au plan desdites couches.

En pratique, et selon l'invention, la couche antiferromagnétique piégeant les couches de référence sont réalisée à base d'un alliage PtMn, alors que la couche antiferromagnétique séparant les deux jonctions tunnel magnétique est à base d'un alliage riche en manganèse Mn, présentant une température de blocage inférieure à l'alliage PtMn. Pratiquement, cette couche antiferromagnétique est à base de IrMn ou de FeMn. En d'autres termes, les couches antiferromagnétiques piégeant les couches de référence sont réalisées en un matériau dont la température de blocage est supérieure (typiquement supérieure à 250 °C) à la température de blocage (typiquement inférieure à 200 °C) de la couche antiferromagnétique séparant les deux jonctions tunnel magnétique.

Chacune des couches de référence est avantageusement constituée par une multicouche comprenant deux couches magnétiques et une couche intermédiaire choisies en un matériau qui comprend le ruthénium, les deux couches magnétiques situées de part et d'autre de cette couche intermédiaire étant couplées antiferromagnétiquement par cette dite couche intermédiaire.

L'invention vise également un procédé pour réaliser l'écriture de tels points mémoire d'une mémoire magnétique.

Selon l'invention, chaque phase d'écriture s'accompagne d'une élévation de température du point mémoire considéré par envoi d'une impulsion de courant dans une ligne conductrice à travers la jonction tunnel associée au point mémoire considéré.

L'écriture selon l'invention s'effectue en trois phases :

■ chauffage du point mémoire en faisant circuler un courant dans la ligne conductrice (bit line) puis à travers la jonction tunnel considérée pour élever la température au dessus de la température de blocage ou idéalement au dessus de la température de Néel de la couche antiferromagnétique séparant les deux couches de stockage ;

■ émission d'une impulsion de courant dans la digit line, afin d'aboutir à l'alignement des aimantations des couches de stockages parallèlement ou antiparallèlement à l'alignement des aimantations des couches de référence en contact avec les barrières tunnel ; l'orientation des aimantations des couches de stockage est définie par la polarisation positive ou négative du courant dans la digit line (c'est à dire par l'orientation du champ magnétique créé dans une direction ou dans la direction opposée) ;

■ définition des états du point mémoire lors du refroidissement :

- coupure du courant de chauffage avant la fin de l'impulsion de courant dans la digit line : définition des états « 00 » et « 11 » en fonction de la polarité du courant traversant la digit line ;

- coupure du courant de chauffage après la fin de l'impulsion de courant dans la digit line : création d'un couplage magnétostatique entre les deux couches de stockage, induisant le renversement de l'aimantation de l'une desdites deux couches pour favoriser un alignement antiparallèle des aimantations, qui est plus stable sur le plan énergétique ; selon la polarité du courant dans la digit line, on définit les états « 01 » et « 10 ».

## BREVE DESCRIPTION DES FIGURES

La manière dont l'invention peut être réalisée et les avantages qui en découlent ressortiront mieux de l'exemple de réalisation qui suit, donné à titre indicatif et non limitatif à l'appui des figures annexées.

Comme déjà indiqué, les figures 1 et 2 sont des représentations schématiques, respectivement de l'architecture d'une mémoire magnétique de type FIMS et de type TA-MRAM selon l'état antérieur de la technique.

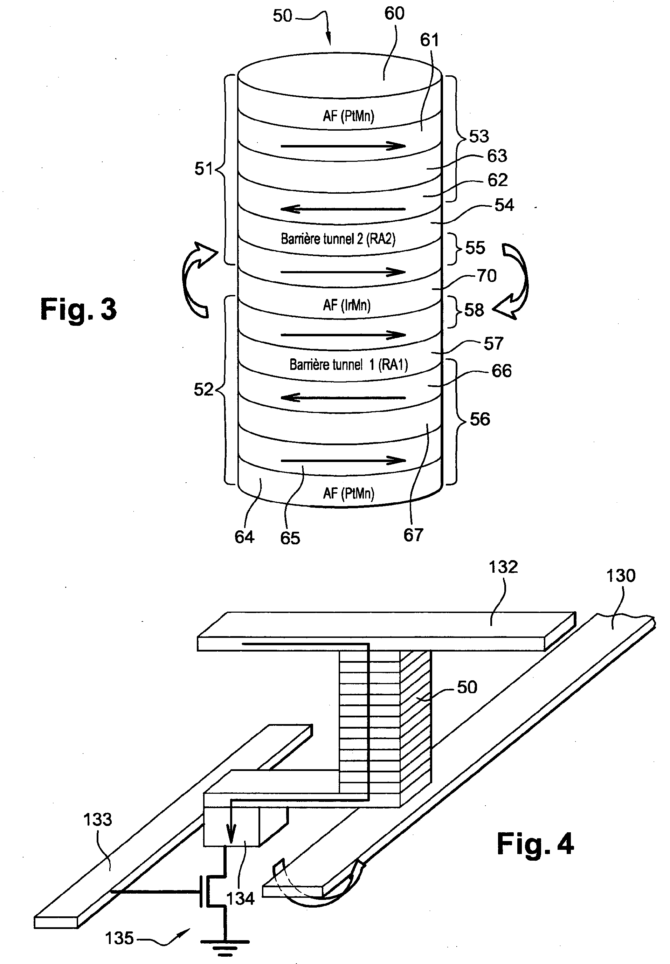

La figure 3 est une représentation schématique d'un point mémoire conforme à l'invention.

La figure 4 est une représentation schématique en perspective d'un point mémoire de l'invention, associé à ses lignes de courant propres à assurer son écriture.

Les figures 5A à 5D sont des représentations schématiques en perspective illustrant le procédé d'écriture conforme à l'invention, afin d'aboutir aux quatre états stables du point mémoire considéré.

La figure 6 est une représentation simplifiée visant à illustrer le principe d'écriture conforme à l'invention.

Les figures 7A et 7B illustrent un diagramme représentatif de la variation de l'intensité traversant certaines lignes de courant en fonction du temps, selon un autre mode de réalisation de l'invention.

## DESCRIPTION DETAILLEE DE L'INVENTION

La mémoire magnétique conforme à l'invention est constituée d'une matrice de points mémoire ou cellules mémoire.

Chacun de ces points mémoires (50) est, selon une caractéristique de l'invention, constitué par deux jonctions tunnel magnétiques (51, 52) séparées l'une de l'autre par une couche (70) réalisée en un matériau antiferromagnétique, et en l'espèce d'une couche en alliage riche en Manganèse, comme par exemple IrMn ou FeMn.

Chacune de ces jonctions tunnel magnétiques (51, 52) est constituée par un empilement de couches comportant une couche de stockage (55, 58), une barrière tunnel (54, 57) et une couche de référence (53, 56).

Il convient de préciser que les deux jonctions tunnel magnétique sont montées inversées l'une par rapport à l'autre, c'est-à-dire que la couche de stockage de chacune d'entre elles est en contact direct avec la couche séparatrice (70) en matériau antiferromagnétique IrMn séparant, comme déjà indiqué, les deux jonctions tunnel magnétiques.

L'aimantation de chacune des couches respectivement de stockage et de référence des deux jonctions tunnel magnétique est située dans le plan principal contenant lesdites couches.

Selon l'invention, les matériaux des couches de stockage et de référence respectivement sont choisis de telle sorte que la décroissance en température du champ de retournement des couches de stockage soit beaucoup plus rapide que celle du champ de retournement des couches de référence.

En d'autres termes, on choisit le matériau de la couche de séparation (70) en matériau antiferromagnétique séparant les couches de stockage (55, 58) de telle sorte que sa température de blocage soit significativement plus faible que celle des matériaux antiferromagnétiques mis en oeuvre dans les couches de référence (53, 56).

Ainsi, lors de l'écriture du point mémoire considéré, celui-ci subit un bref échauffement jusqu'à une température pouvant typiquement atteindre 200 °C, ce qui a pour effet de passer au dessus de la température de blocage de la couche (70) en matériau antiferromagnétique qui piège les aimantations des couches de stockage (55, 58). Le couplage d'échange étant réduit à zéro, le champ de retournement des couches de stockage atteint sa valeur minimale lorsque la température de la couche antiferromagnétique (70) atteint la température de Néel du matériau qui la constitue, qui correspond à la température, où l'ordre magnétique, même à courte distance, disparaît.

Les couches de stockage peuvent être constituées d'une monocouche en matériau ferromagnétique, typiquement constitué de cobalt, de nickel ou de fer, ou d'un alliage de ces différents éléments. Ces alliages peuvent en outre être dopés au bore.

La couche de référence (53, 56) de chacune des jonctions tunnel magnétique est constituée d'une couche antiferromagnétique synthétique comprenant un empilement de deux couches ferromagnétiques, respectivement (61, 62) et (65, 66) séparées par une couche en un matériau non magnétique, respectivement (63) et (67). Les couches ferromagnétiques (61, 62) et (65, 66) sont par exemple réalisées en un alliage à base de Fe, Co, et Ni, éventuellement dopé au Bore pour les couches en contact avec la barrière tunnel. La couche en matériau non magnétique est quant à elle généralement réalisée en Ru ou autre « spacer » permettant un couplage RKKY antiferromagnétique fort.

Du coté opposé à leur zone de contact avec la barrière tunnel correspondante, lesdites couches de référence sont en contact avec une couche en un matériau anti-ferromagnétique (60, 64), typiquement réalisée en PtMn ou autre alliage présentant une température de blocage élevée (supérieure à 280 °C).

L'épaisseur des couches magnétiques constitutives des couches de stockage est choisie de telle sorte à favoriser un alignement antiparallèle des aimantations lorsque la couche de stockage est chauffée en l'absence de tout champ magnétique.

Les barrières tunnel (54, 57) sont réalisées en un matériau isolant ou semiconducteur, notamment en alumine ou oxyde de magnésium MgO.

Chacun de ces empilements est susceptible de subir une élévation brève de température, afin de favoriser le basculement de l'aimantation de la couche de stockage, en l'espèce d'un état parallèle à un état antiparallèle par rapport à la couche de référence à laquelle elle est couplée.

A cet effet, chacun des points mémoire de la matrice est placé entre une ligne conductrice supérieure (132) dite bit line et un transistor de commutation (135) associé à une ligne de contrôle (133), cette dernière assurant, ainsi que déjà précisé, l'ouverture ou la fermeture du transistor considéré. De fait, en rendant passant le transistor du point mémoire que l'on souhaite écrire, et en envoyant une impulsion de courant dans la ligne conductrice supérieure correspondante (132), cette impulsion de courant traverse le point mémoire considéré et provoque son échauffement.

L'abaissement du champ de retournement lié à l'élévation locale de température est beaucoup plus important que la largeur de la distribution de champ de retournement à température ambiante.

De fait, en envoyant une impulsion de courant dans une ligne conductrice inférieure (130) dite digit line, générant un champ magnétique dont l'orientation est dépendante du sens de circulation de ladite impulsion de courant dans la ligne conductrice, pendant le refroidissement du point mémoire adressé, on ne fait commuter que l'aimantation des couches de stockage de la jonction considérée.

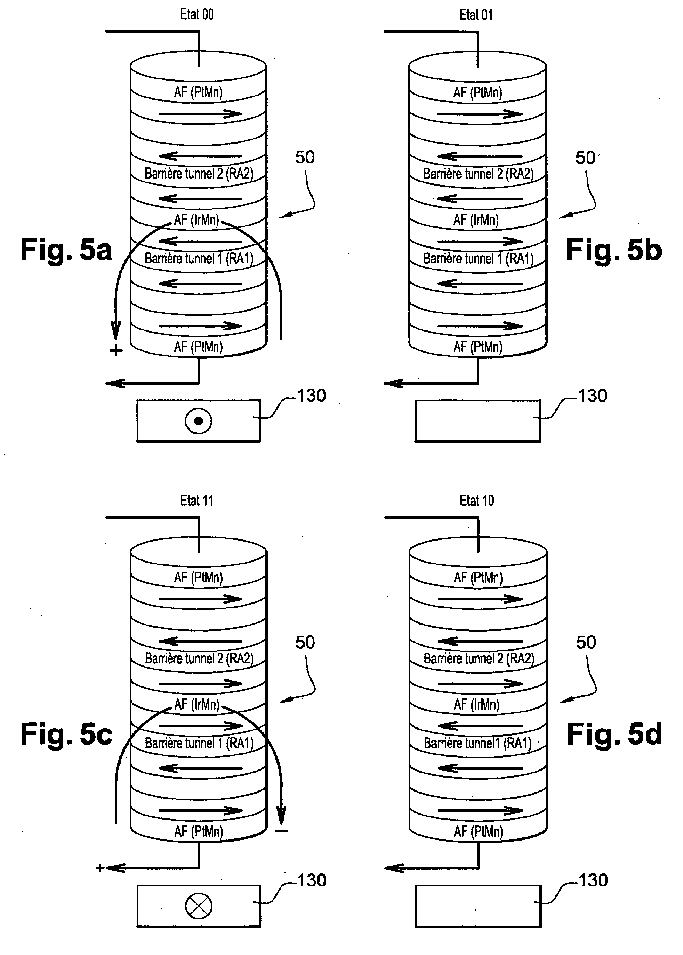

Conformément à l'invention et afin d'aboutir aux quatre états stables d'écriture souhaitée, on procède de la manière suivante, selon les différentes étapes illustrées au sein des figures 5A à 5D :

1 - Ecriture de l'état « 00 »

On applique une impulsion de courant pour chauffer la couche de séparation (70) en matériau antiferromagnétique séparant les couches de stockage au dessus de sa température de blocage, et préférentiellement au dessus de sa température de Néel, le transistor de commande correspondant étant bien entendu rendu passant.

Simultanément, on génère un champ magnétique positif en faisant transiter le courant approprié dans la digit line (130) et ce, pour aligner les aimantations des couches de stockage parallèlement à celle des couches de référence en contact avec la barrière tunnel.

Par « champ magnétique positif », on désigne par convention le champ magnétique vu par les couches de stockage, dont l'orientation est parallèle à l'aimantation des couches de référence en contact avec la barrière tunnel.

Par « champ magnétique négatif », on désigne selon la même convention le champ magnétique vu par les couches de stockage, dont l'orientation est antiparallèle à l'aimantation des couches de référence en contact avec la barrière tunnel.

Le courant de chauffage est alors stoppé et la structure refroidie tout en étant toujours maintenue sous l'influence du champ magnétique précité, assurant ainsi le maintien de l'orientation des aimantations des couches de stockage parallèlement à la direction des aimantations des couches de référence en contact avec la barrière tunnel (figure 5A).

2 - Ecriture de l'état « 01 »

Comme dans le cas précédent, on échauffe la jonction tunnel en faisant circuler un courant à travers la bit line (132). Lorsque la température excède la température de blocage de la couche de séparation (70) en matériau antiferromagnétique séparant les couches de stockage, et préférentiellement excède sa température de Néel, les aimantations des couches de stockage sont libérées, et peuvent être renversées par l'application d'un champ magnétique local.

Après chauffage, on envoie une impulsion de courant dans la digit line (130) pour générer un champ magnétique positif (selon la convention précédemment énoncée), afin d'aligner les aimantations des couches de stockage parallèlement avec l'aimantation des couches de référence en contact avec la barrière tunnel.

On stoppe le courant dans la digit line, conduisant à la relaxation de l'aimantation desdites couches de stockage selon leur configuration de plus faible énergie, à savoir une orientation antiparallèle. Cette configuration résulte du couplage magnétostatique qui existe entre les deux couches ferromagnétiques de stockage à travers la couche de séparation en matériau antiferromagnétique (70). En raison de la dissymétrie née de la différence d'épaisseur des couches ferromagnétiques des couches de stockage, il est possible de contrôler quelle couche de stockage reste alignée dans sa direction de saturation, et quelle couche s'oriente antiparallèlement.

Dans l'exemple de la figure 5B, la couche (55) est légèrement plus épaisse que la couche (58) : c'est donc elle qui conserve son aimantation orientée parallèlement.

3 - Ecriture de l'état « 11 »

On reprend le même procédé que celui décrit en relation avec l'écriture de l'état « 00 », à l'exception de la mise en oeuvre d'un champ magnétique négatif (selon la convention énoncée précédemment). Ce faisant, on génère un alignement antiparallèle de l'aimantation des couches de stockage par rapport à celle des couches de référence en contact avec la barrière tunnel.

4 - Ecriture de l'état « 10 »

On reprend le même procédé que celui décrit en relation avec l'écriture de l'état « 01 », à l'exception de la mise en oeuvre d'un champ magnétique négatif, toujours selon la même convention.

Il est connu que dans une mémoire magnétique, la résistance de la jonction tunnel est donnée par les orientations relatives de l'aimantation des couches magnétiques situées de part et d'autre de la barrière tunnel. Lorsque ces orientations sont parallèles, la résistance RAp est faible alors que la résistance est maximum en configuration antiparallèle (RAap).

Dans le cas de la présente invention, la résistance des différents états peut se définir comme suit :

1) état « 00 » : $R = RA_{1p} + RA_{2p}$

où $RA_1$ et $RA_2$ sont les produits résistance x surface respectifs des deux barrières tunnel.

2) état « 01 » : $R = RA_{1ap} + RA_{2p}$

3) état « 10 » : $R = RA_{1p} + RA_{2ap}$

4) état « 11 » : $R = RA_{1ap} + RA_{2ap}$

Afin de pouvoir disposer d'une différence de résistance sensiblement identique entre chacun de ces états, on choisit la résistance de la seconde barrière tunnel comme étant la moitié de la première, c'est-à-dire $RA_{2p} = 0,5 \times RA_{1p}$.

Comme de manière connue $RA_{1ap} = (1 + TMR) RA_{1p}$, où TMR est la magnétorésistance tunnel, on aboutit donc aux résistances respectives :

$$1) \quad R_{00} = 1,5\ RA_{1p}$$

$$2) \quad R_{10} = 0,5\ (3 + TMR)\ RA_{1p}$$

$$3) \quad R_{01} = (1,5 + TMR)\ RA_{1p}$$

$$4) \quad R_{11} = 1,5\ (1 + TMR)\ RA_{1p}$$

Ainsi, dans cette configuration, la différence de résistance entre chacun de ces états est égale à $0,5 \times TMR \times RA_{1p}$.

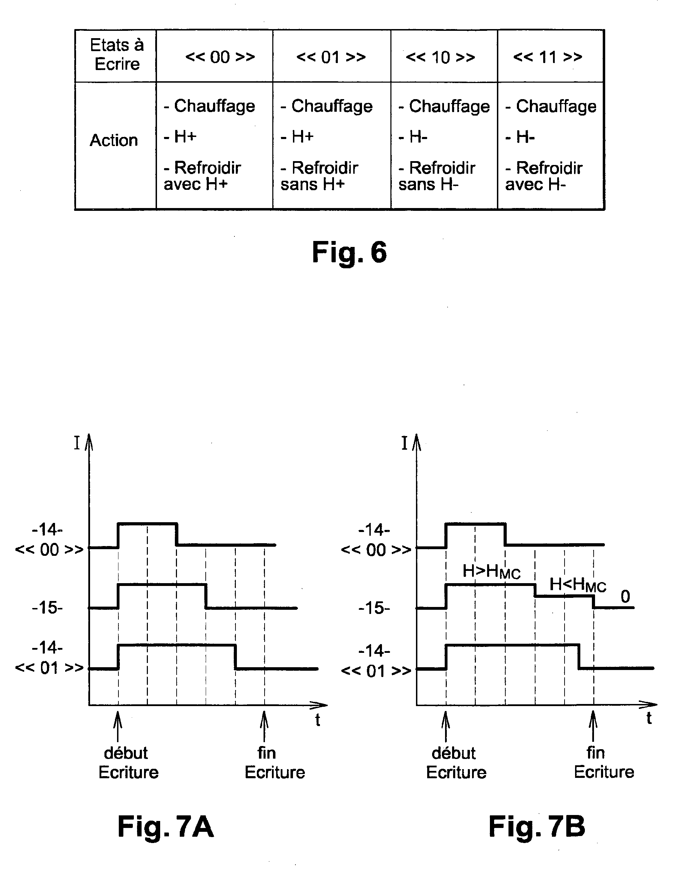

On a illustré dans la figure 6 le mode de fonctionnement sous forme de tableau de l'écriture du point considéré, selon cette forme de réalisation.

Avantageusement, et selon l'invention, la section transversale des jonctions tunnel magnétique est circulaire, dont de rapport d'aspect AR égal à 1 (AR est le rapport des longueurs du grand axe sur le petit axe d'une ellipse), de telle sorte à minimiser l'anisotropie de forme et donc le champ de renversement des aimantations des couches de stockage. Cependant, lors des phases d'écriture des états « 01 » et « 10 », la relaxation des aimantations dans une configuration antiparallèle s'effectue à une température voisine de 200 °C sans champ magnétique appliqué. Ce faisant, le système ne dispose que de très peu d'énergie pour maintenir cette configuration stable dans le temps. La stabilité thermique du système n'est que de quelques ns à quelques dizaines de ns selon le volume des couches de stockage.

On peut définir un diamètre minimal du point mémoire pour lequel la stabilité thermique est d'au moins 10 ns, permettant ainsi la relaxation dans la configuration antiparallèle (dont la durée est inférieure ou égale à 3 ns) et un refroidissement qui assure le piégeage des aimantations.

Ainsi, dans le cas d'une anisotropie magnétocristalline de Hk - 15 Oersted, une épaisseur de la couche de stockage de 3 nm, une stabilité $\tau$ = 10 *ns*, une aimantation de la couche de stockage Ms = 1000 emu/cc, et une température T = 473 K, on peut déterminer le diamètre minimum par la relation :

$$D = \sqrt{\frac{4}{\pi}\left(\frac{2.K_B T \ln 10}{Ms.Hk\tau}\right)}$$

conduisant à un diamètre qui ne doit pas être inférieur ou égale à 90 nm.

Si le diamètre est inférieur à 90 nm, il faut soit augmenter l'épaisseur de la couche de stockage, soit son aimantation, soit son anisotropie en changeant la nature des matériaux qui la composent, soit encore, en prenant un produit AR supérieur à 1.

Cette dernière option est pénalisante pour le fonctionnement de la mémoire, car elle induit une augmentation de la consommation électrique à des niveaux proches de celle d'une MRAM standard.

On peut également stabiliser le système en appliquant un champ magnétique H par la digit line, dont l'intensité répond à la relation $0 < H < H_{MS}$, où $H_{MS}$ est le champ de couplage magnétostatique entre les couches de stockage.

Selon une variante de l'invention, la structure précédemment décrite est placée entre deux matériaux de type barrière thermique à faible conductivité thermique, comme par exemple en GeSbTe ou BiTe, et ce, dans un souci de réduire la densité de courant nécessaire au chauffage du point mémoire. Ces matériaux jouent le rôle d'écran thermique et bloquent la chaleur produite ou coeur des jonctions tunnel.

Par ailleurs, on peut placer la cellule TA-MRAM multibit décrite dans la présente invention dans une architecture mémoire matricielle, telle qu'illustrée sur la figure 1. Dans cette configuration, le procédé pour écrire les différents états est le suivant :

Selon une première phase, on ouvre la word line (16) afin de placer tous les transistors (12) de la colonne considérée en mode ON.

Puis, un courant de chauffage est envoyé dans toutes les bit lines (14) afin de permettre l'écriture de tous les points mémoire de la colonne.

Ensuite, un courant permettant de générer un champ magnétique positif (selon la convention précédemment énoncée) est envoyé dans la digit line (15) pour orienter l'aimantation des couches de stockage parallèlement à l'aimantation des couches de référence en contact avec les barrières tunnel.

Afin d'écrire l'état « 00 », on arrête le chauffage dans le point mémoire concerné en stoppant le courant dans la bit line (14). Ledit point mémoire refroidit donc sous l'action du champ magnétique positif généré par la digit line (15).

Pour l'écriture de l'état « 01 » dans la colonne concernée, on stoppe ou on diminue (notamment à une valeur inférieure au champ de couplage magnétostatique entre les deux couches de stockage situées de part et d'autre de la couche de piégeage en matériau antiferromagnétique), le champ magnétique généré par la digit line (15) avant de refroidir, c'est à dire, avant de couper le courant dans la bit line (14).

Selon ce mode de réalisation, les états « 01 » sont nécessairement écrits postérieurement aux états « 00 », car il est nécessaire d'attendre l'arrêt du courant dans la digit line (15).

On a représenté au sein des figures 7A et 7B un diagramme illustrant la variation d'intensité dans la bit line (14) et dans la digit line (15) en fonction du temps, pour écrire les états « 00 » et « 01 », et ce, selon deux variantes de l'invention, c'est à dire, en annulant le champ magnétique généré par la digit line (15) (figure 7A) ou en diminuant ledit champ (figure 7B). Le mode de réalisation correspondant à la figure 7B est plus particulièrement requis lorsque la taille du point mémoire est inférieure ou égale à 90 nm, afin de créer un champ stabilisant lors du refroidissement. En effet, au dessous de 90 nm, les fluctuations thermiques risquent de désorienter rapidement les aimantations des couches de stockages.

L'écriture des états « 11 » et « 10 » répond au même procédé que celui précédemment décrit, mais en générant un champ magnétique négatif (selon la convention énoncée) en lieu et place d'un champ magnétique positif.

Il résulte de la présente invention un certain nombre d'avantages, parmi lesquels on peut citer :

■ la nécessité d'une seule ligne de champ pour écrire la cellule TA-MRAM multibit, alors que les cellules de l'art antérieur en nécessitent au moins deux. Ce faisant, l'architecture est simplifiée et se ramène à celle classique d'une cellule TA-MRAM à deux états. Cette technologie est donc directement implantable dans les produits mettant en oeuvre de telles cellules, permettant ainsi de doubler la densité d'informations stockées ;

■ la consommation d'une telle cellule est réduite par rapport aux cellules de l'art antérieur, dans la mesure où un seul champ magnétique est généré. Si l'on considère qu'il faut appliquer un champ magnétique pour écrire chaque état, la réduction de consommation atteint environ 20 %. Si au surplus, on accepte de lire l'information avant de l'écrire, la réduction de consommation est voisine de 40 %, dans la mesure où certaines transitions entre états peuvent s'effectuer sans champ magnétique. En effet, les transitions « 00 » vers « 01 » et « 11 » vers « 10 » ne nécessitent que du chauffage (pas de champ). De fait, dans deux cas sur les douze possibles, on peut écrire sans champ ;

■ l'endurance au claquage de la cellule est améliorée par rapport aux cellules de l'art antérieur. En effet, elle comporte une double barrière tunnel, et non pas une simple barrière tunnel comme les cellules de l'art antérieur. Ce faisant, la densité de puissance nécessaire au chauffage de la couche de piégeage antiferromagnétique séparant les couches de stockage de l'invention est identique à celle nécessaire pour une cellule à une seule barrière tunnel mais la tension vue par chaque barrière est réduite. En effet, pour rappel, la puissance nécessaire s'exprime par la relation $P = RA.j^2$ , où RA est le produit résistance x surface, et j la densité de courant. Selon la présente invention:

$$P = RA \cdot j^2 = (RA_1 + RA_2) \cdot j^2$$

On rappelle que $RA_1 = \frac{1}{2} RA_2$ et donc $RA_1 = \frac{2}{3} RA$

Ainsi, la tension V aux bornes du système s'écrit:

$$V = RA \cdot j = \frac{1}{3} RA \cdot j + \frac{2}{3} RA \cdot j = \frac{1}{3} V + \frac{2}{3} V$$

De sorte que la tension sur chaque barrière tunnel est réduite avec un maximum de $\frac{2}{3}$ V.

## Revendications

1. Mémoire magnétique à écriture assistée thermiquement, constituée de points mémoire ou cellules mémoire (50), dont chacun est constitué d'une double jonction tunnel magnétique (51, 52) séparée l'une de l'autre par une couche (70) réalisée en un matériau antiferromagnétique, et dont l'ordre d'empilement des couches qui les constituent est inversé l'une par rapport à l'autre, chacune des jonctions tunnel magnétique (51, 52) comprenant :

   - une couche magnétique de référence (53, 56), dite « couche piégée », dont l'aimantation est de direction fixe ;
   - une couche magnétique de stockage (55, 58), dite « couche libre », dont la direction de l'aimantation est variable, et constituée d'au moins une couche réalisé en un matériau ferromagnétique à aimantation dans le plan de la couche, couplée magnétiquement par échange avec une couche de piégeage réalisée en un matériau antiferromagnétique et constituée par la couche de séparation (70) des deux jonctions tunnel magnétique ;
   - une couche isolante (54, 57) interposée entre la couche de référence et la couche de stockage, constituant la barrière tunnel de la jonction tunnel magnétique considérée ;

   *caractérisée :*

   - **en ce que** la température de blocage de la couche (70) réalisée en matériau antiferromagnétique séparant les couches de stockage (55, 58) est inférieure à la température de blocage de la couche de référence de la jonction tunnel magnétique correspondante ;
   - **en ce que** le produit RA résistance x surface des deux barrières tunnel (54, 57) est différente ;
   - **en ce que** chaque point mémoire (50) comprend des moyens d'échauffement (132 - 135) des couches de stockage à une température supérieur à la température de blocage desdites couches de stockage (55, 58);
   - **en ce que** la mémoire comprend des moyens (130) d'application d'un champ magnétique apte à orienter l'aimantation de la couche de stockage ou des couches de stockage de chaque point mémoire (50) par rapport à l'aimantation de la couche de référence ou des couches de référence sans modifier l'orientation des couches de référence considérées ;
   - et **en ce que** les couches de stockage (55, 58) sont couplées magnétostatiquement à travers la couche (70) réalisée en matériau antiferromagnétique séparant lesdites couches de stockage, de telle façon que les aimantations de ces dernières se placent dans une configuration antiparallèle lorsque la température dans la jonction tunnel magnétique concernée excède la température de blocage de ladite couche (70) en matériau antiferromagnétique et en l'absence de champ magnétique appliquée à ladite mémoire, ou sous l'influence d'un champ magnétique d'intensité inférieure au couplage magnétostatique entre lesdites couches de stockage.

2. Mémoire magnétique à écriture assistée thermiquement selon la revendication 1, *caractérisée* **en ce que** le produit Résistance x Surface de l'une des deux barrières tunnel (54, 57) est sensiblement égale à la moitié de l'autre.

3. Mémoire magnétique à écriture assistée thermiquement selon l'une des revendications 1 et 2, *caractérisée* **en ce que** les moyens pour faire varier l'orientation du champ magnétique des couches de stockage sont constitués d'une seule ligne conducteur (130), située au dessus ou au dessous du point mémoire magnétique considéré.

4. Mémoire magnétique à écriture assistée thermiquement selon l'une des revendications 1 à 3, *caractérisée* **en ce que** les points mémoire (50) sont de section transversale elliptique ou circulaire.

5. Mémoire magnétique à écriture assistée thermiquement selon l'une des revendications 1 à 4, *caractérisée* **en ce que** les couches de stockage sont réalisées en un matériau à base d'un alliage de Fe, Co, Ni (CoFe ou NiFe), susceptible d'être dopé avec du Bore, notamment lorsque les barrières tunnel sont réalisées en MgO.

6. Mémoire magnétique à écriture assistée thermiquement selon l'une des revendications 1 à 5, *caractérisée* **en ce que** les épaisseurs des couches de stockage sont différentes.

7. Mémoire magnétique à écriture assistée thermiquement selon l'une des revendications 1 à 6, *caractérisée* **en ce que** l'aimantation de chacune des couches de stockage et de référence est sensiblement parallèle au plan desdites couches.

8. Mémoire magnétique à écriture assistée thermiquement selon l'une des revendications 1 à 7, *caractérisée* **en ce que** les couches antiferromagnétiques (60, 64) piégeant les couches de référence (53, 56) sont réalisées en un matériau dont la température de blocage est supérieure à la température de blocage de la couche antiferromagnétique (70) séparant les deux jonctions tunnel magnétique (51, 52).

9. Mémoire magnétique à écriture assistée thermiquement selon la revendication *8,* *caractérisée* **en ce que** les couches antiferromagnétiques (60, 64) piégeant les couches de référence (53, 56) sont réalisées en un matériau dont la température de blocage est supérieure à 250 °C, et notamment sont réalisées en PtMn.

10. Mémoire magnétique à écriture assistée thermiquement selon l'une des revendications 8 et 9, *caractérisée* **en ce que** la température de blocage de la couche antiferromagnétique (70) séparant les deux jonctions tunnel magnétique (51, 52) est inférieure à 200 °C, ladite couche étant réalisée à base d'un alliage riche en manganèse, et notamment en IrMn ou Fe Mn.

11. Mémoire magnétique à écriture assistée thermiquement selon l'une des revendications 1 à 10, *caractérisée* **en ce que** chacune des couches de référence est constituée d'une multicouche comprenant deux couches magnétiques et une couche intermédiaire choisies en un matériau qui comprend le ruthénium, les deux couches magnétiques situées de part et d'autre de cette couche intermédiaire étant couplées antiferromagnétiquement par cette dite couche intermédiaire.

12. Procédé pour réaliser l'écriture de points mémoire d'une mémoire magnétique constituée de points mémoire ou cellules mémoire (50) selon la revendication 1, *caractérisé* **en ce que** chaque phase d'écriture s'accompagne d'une élévation de température du point mémoire considéré par envoi d'une impulsion de courant dans une ligne conductrice ou bit line associée au point mémoire considéré, et **en ce que** l'écriture proprement dite s'effectue en trois phases :

■ chauffage du point mémoire en faisant circuler un courant dans la ligne conductrice (bit line) puis à travers la jonction tunnel considérée pour élever la température au dessus de la température de blocage de la couche antiferromagnétique (70) séparant les deux couches de stockage (55, 58) ;
■ émission d'une impulsion de courant dans une ligne conductrice (digit line) (15), afin d'aboutir à l'alignement des aimantations des couches de stockages (55, 58) parallèlement ou antiparallèlement à l'alignement des aimantations des couches de référence en contact avec les barrières tunnel ;
■ définition des états du point mémoire lors du refroidissement:

- coupure du courant de chauffage avant la fin de l'impulsion de courant dans la digit line : définition des états « 00 » et « 11 » en fonction de la polarité du courant traversant la digit line ;
- ou coupure du courant de chauffage après la fin de l'impulsion de courant dans la digit line : création d'un couplage magnétostatique entre les deux couches de stockage (55, 58), induisant le renversement de l'aimantation de l'une desdites deux couches pour favoriser un alignement antiparallèle des aimantations, et qui, selon la polarité du courant dans la digit line, définit les états « 01 » et « 10 ».

**EP 2 073 210 B1**

13. Procédé pour réaliser l'écriture de points mémoire d'une mémoire magnétique constituée de points mémoire ou cellules mémoire (50) selon la revendication 1, lesdits points mémoire étant intégrés dans une architecture de type matricielle, dans laquelle chaque point mémoire est associé à un transistor de commutation (12) commandé par une ligne d'adressage (16) (word line) destinée à commander l'ouverture ou la fermeture du canal desdits transistors, *caractérisé* **en ce que** l'écriture de la matrice s'effectue par colonne en ouvrant la word line (16) afin de placer tous les transistors (12) de la colonne considérée en mode ON, puis en envoyant un courant de chauffage dans toutes les bit lines (14) afin de permettre l'écriture de tous les points mémoire de la colonne selon le procédé de la revendication 12.

14. Procédé pour réaliser l'écriture de points mémoire d'une mémoire magnétique selon la revendication 13, *caractérisé* **en ce que** le champ magnétique généré par la digit line (15) lors de l'écriture des états « 01 » et « 10 » est diminué à une valeur inférieure au champ de couplage magnétostatique entre les deux couches de stockage (55, 58) situées de part et d'autre de la couche de piégeage (70) en matériau antiferromagnétique.

**Patentansprüche**

1. Magnetspeicher mit thermisch unterstütztem Schreiben, bestehend aus Speicherstellen oder Speicherzellen (50), wovon jede aus einem doppelten magnetischen Tunnelübergang (51, 52) besteht, die durch eine aus einem antiferromagnetischen Material hergestellte Schicht (70) voneinander getrennt sind, und deren Stapelreihenfolge der sie bildenden Schichten im Verhältnis zueinander umgekehrt ist, wobei jeder der magnetischen Tunnelübergänge (51, 52) aufweist:

   - eine magnetische Bezugsschicht (53, 56), "eingeschlossene Schicht" genannt, deren Magnetisierung von festgelegter Richtung ist;
   - eine magnetische Speicherschicht (55, 58), "freie Schicht" genannt, deren Richtung der Magnetisierung variabel ist, und die aus mindestens einer Schicht aus einem ferromagnetischen Material mit Magnetisierung in der Ebene der Schicht besteht, die magnetisch durch Austausch mit einer Fangschicht gekoppelt ist, die aus einem antiferromagnetischen Material hergestellt ist, und durch die Trennschicht (70) der zwei magnetischen Tunnelübergänge gebildet ist;
   - eine zwischen die Bezugsschicht und die Speicherschicht eingesetzte Isolierschicht (54, 57), welche die Tunnelsperre des jeweiligen magnetischen Tunnelübergangs bildet;

   **dadurch gekennzeichnet:**

   - **dass** die Sperrtemperatur der aus antiferromagnetischem Material hergestellten Schicht (70), welche die Speicherschichten (55, 58) trennt, niedriger ist als die Sperrtemperatur der Bezugsschicht des entsprechenden magnetischen Tunnelübergangs;
   - **dass** das Produkt RA Widerstand x Fläche der zwei Tunnelsperren (54, 57) unterschiedlich ist;
   - **dass** jede Speicherstelle (50) Einrichtungen (132 - 135) zum Erwärmen der Speicherschichten auf eine Temperatur umfasst, die höher ist als die Sperrtemperatur der Speicherschichten (55, 58);
   - **dass** der Speicher Einrichtungen (130) zum Anlegen eines Magnetfelds umfasst, das in der Lage ist, die Magnetisierung der Speicherschicht oder der Speicherschichten jeder Speicherstelle (50) im Verhältnis zur Magnetisierung der Bezugsschicht oder der Bezugsschichten auszurichten, ohne die Ausrichtung der jeweiligen Bezugsschichten zu verändern;
   - und **dass** die Speicherschichten (55, 58) magnetostatisch über die aus antiferromagnetischem Material hergestellte Schicht (70), welche die Speicherschichten trennt, so gekoppelt sind, dass sich die Magnetisierungen dieser Letzteren in eine antiparallele Konfiguration begeben, wenn die Temperatur im jeweiligen magnetischen Tunnelübergang die Sperrtemperatur der Schicht (70) aus antiferromagnetischem Material und in Abwesenheit des an den Speicher angelegten Magnetfelds oder unter dem Einfluss eines Magnetfelds mit einer Stärke übersteigt, die niedriger ist als die magnetostatische Kopplung zwischen den Speicherschichten.

2. Magnetspeicher mit thermisch unterstütztem Schreiben nach Anspruch 1, **dadurch gekennzeichnet, dass** das Produkt Widerstand x Fläche einer der zwei Tunnelsperren (54, 57) im Wesentlichen gleich der Hälfte der anderen ist.

3. Magnetspeicher mit thermisch unterstütztem Schreiben nach einem der Ansprüche 1 und 2, **dadurch gekennzeichnet, dass** die Einrichtungen, um die Ausrichtung des Magnetfelds der Speicherschichten sich verändern zu lassen, aus einer einzigen Leiterbahn (130) bestehen, die sich über oder unter der jeweiligen magnetischen Speicherstelle befindet.

4. Magnetspeicher mit thermisch unterstütztem Schreiben nach einem der Ansprüche 1 bis 3, **dadurch gekennzeichnet, dass** die Speicherstellen (50) von elliptischem oder kreisförmigem Querschnitt sind.

5. Magnetspeicher mit thermisch unterstütztem Schreiben nach einem der Ansprüche 1 bis 4, **dadurch gekennzeichnet, dass** die Speicherschichten aus einem Material auf Basis einer Fe-, Co-, Ni- (CoFe- oder NiFe-)-Legierung hergestellt sind, die mit Bor dotiert werden kann, insbesondere wenn die Tunnelsperren aus MgO hergestellt sind.

6. Magnetspeicher mit thermisch unterstütztem Schreiben nach einem der Ansprüche 1 bis 5, **dadurch gekennzeichnet, dass** die Dicken der Speicherschichten unterschiedlich sind.

7. Magnetspeicher mit thermisch unterstütztem Schreiben nach einem der Ansprüche 1 bis 6, **dadurch gekennzeichnet, dass** die Magnetisierung jeder der Speicher- und Bezugsschichten im Wesentlichen parallel zur Ebene der Schichten ist.

8. Magnetspeicher mit thermisch unterstütztem Schreiben nach einem der Ansprüche 1 bis 7, **dadurch gekennzeichnet, dass** die antiferromagnetischen Schichten (60, 64), welche die Bezugsschichten (53, 56) einschließen, aus einem Material hergestellt sind, dessen Sperrtemperatur höher ist als die Sperrtemperatur der antiferromagnetischen Schicht (70), welche die zwei magnetischen Tunnelübergänge (51, 52) trennt.

9. Magnetspeicher mit thermisch unterstütztem Schreiben nach Anspruch 8, **dadurch gekennzeichnet, dass** die antiferromagnetischen Schichten (60, 64), welche die Bezugsschichten (53, 56) einschließen, aus einem Material hergestellt sind, dessen Sperrtemperatur höher als 250°C ist, und insbesondere aus PtMn hergestellt sind.

10. Magnetspeicher mit thermisch unterstütztem Schreiben nach einem der Ansprüche 8 und 9, **dadurch gekennzeichnet, dass** die Sperrtemperatur der antiferromagnetischen Schicht (70), welche die zwei magnetischen Tunnelübergänge (51, 52) trennt, niedriger als 200°C ist, wobei die Schicht auf Basis einer Legierung hergestellt ist, die reich an Mangan und insbesondere an IrMn oder FeMn ist.

11. Magnetspeicher mit thermisch unterstütztem Schreiben nach einem der Ansprüche 1 bis 10, **dadurch gekennzeichnet, dass** jede der Bezugsschichten aus einer Mehrfachschicht besteht, die zwei magnetische Schichten und eine Zwischenschicht umfasst, die aus einem Material ausgewählt sind, das Ruthenium umfasst, wobei die zwei magnetischen Schichten, die sich beidseits dieser Zwischenschicht befinden, durch diese besagte Zwischenschicht antiferromagnetisch gekoppelt sind.

12. Verfahren zum Realisieren des Beschreibens von Speicherstellen eines Magnetspeichers nach Anspruch 1, der aus Speicherstellen oder Speicerzellen (50) besteht, **dadurch gekennzeichnet, dass** jede Schreibphase mit einer Temperaturerhöhung der jeweiligen Speicherstelle durch Übertragen eines Stromimpulses in einer Leiterbahn oder Bitleitung einhergeht, die der jeweiligen Speicherstelle zugeordnet ist, und dass das eigentliche Schreiben in drei Phasen erfolgt:

• Erwärmen der Speicherstelle, indem bewirkt wird, dass ein Strom in der Leiterbahn (Bit-Leitung), dann über den jeweiligen Tunnelübergang fließt, um die Temperatur über die Sperrtemperatur der die zwei Speicherschichten (55, 58) trennenden antiferromagnetischen Schicht (70) anzuheben;
• Abgeben eines Stromimpulses in eine Leiterbahn (Digit-Leitung) (15), um die Ausrichtung der Magnetisierungen der Speicherschichten (55, 58) parallel oder antiparallel zur Ausrichtung der Magnetisierungen der Bezugsschichten in Kontakt mit den Tunnelsperren zu erzielen;
• Definieren der Zustände der Speicherstelle beim Abkühlen:

- Unterbrechen des Erwärmungsstroms vor dem Ende des Stromimpulses in der Digit-Leitung: Definieren der Zustände "00" und "11" in Abhängigkeit von der Polarität des die Digit-Leitung durchfließenden Stroms;
- oder Unterbrechen des Erwärmungsstroms nach dem Ende des Stromimpulses in der Digit-Leitung: Herstellen einer magnetostatischen Kopplung zwischen den zwei Speicherschichten (55, 58), Induzieren der Umkehrung der Magnetisierung einer der zwei Schichten, um eine antiparallele Ausrichtung der Magnetisierungen zu begünstigen, und die, je nach der Polarität des Stroms in der Digit-Leitung, die Zustände "01" und "10" definiert.

**13.** Verfahren zum Realisieren des Beschreibens von Speicherstellen eines Magnetspeichers nach Anspruch 1, der aus Speicherstellen oder Speicherzellen (50) besteht, wobei die Speicherstellen in eine matrixartige Architektur integriert sind, in der jede Speicherstelle einem Schalttransistor (12) zugeordnet ist, der von einer Adressierungsleitung (16) (Wort-Leitung) gesteuert wird, die dazu bestimmt ist, das Öffnen oder Schließen des Kanals der Transistoren zu steuern, **dadurch gekennzeichnet, dass** das Schreiben der Matrix pro Spalte erfolgt, indem die Wort-Leitung (16) geöffnet wird, um alle Transistoren (12) der jeweiligen Spalte in einen EIN-Modus zu versetzen, indem dann ein Erwärmungsstrom in allen Bit-Leitungen (14) übertragen wird, um das Schreiben aller Speicherstellen der Spalte gemäß dem Verfahren des Anspruchs 12 zuzulassen.

**14.** Verfahren nach Anspruch 13 zum Realisieren des Beschreibens von Speicherstellen eines Magnetspeichers, **dadurch gekennzeichnet, dass** das Magnetfeld, das durch die Digit-Leitung (15) beim Schreiben der Zustände "01" und "10" erzeugt wird, auf einen Wert unter dem magnetostatischen Kopplungsfeld zwischen den zwei Speicherschichten (55, 58) abgesenkt wird, die sich beidseits der Fangschicht (70) aus antiferromagnetischem Material befinden.

**Claims**

**1.** A thermally assisted magnetic write memory, consisting of memory points or memory cells (50), each of which consists of a double magnetic tunnel junction (51, 52) separated from one another by a layer (70) made of an antiferromagnetic material, and whereof the stacking order of the layers constituting them is reversed with regard to one another, each of the magnetic tunnel junctions (51, 52) comprising:

- a magnetic reference layer (53, 56), called "pinned layer" whereof the magnetization has a fixed direction;
- a magnetic storage layer (55, 58), called "free layer" whereof the magnetization direction is variable, and consists of at least one layer made from a ferromagnetic material having an in-plane magnetization of the layer, magnetically coupled by exchange with a pinning layer made from an antiferromagnetic material and consisting of the layer (70) separating the two magnetic tunnel junctions;
- an insulating layer (54, 57) inserted between the reference layer and the storage layer, constituting the tunnel barrier of the magnetic tunnel junction concerned;

*characterized:*

- **in that** the blocking temperature of the layer (70) made of antiferromagnetic material separating the storage layers (55, 58) is lower than the blocking temperature of the reference layer of the corresponding magnetic tunnel junction;
- **in that** the product RA resistance x area of the two tunnel barriers (54, 57) is different;
- **in that** each memory point (50) comprises means (132 - 135) for heating the storage layers to a temperature above the blocking temperature of said layers;
- **in that** the memory comprises means (130) for applying a magnetic field for orienting the magnetization of the storage layer or layers of each memory point (50) with regard to the magnetization of the reference layer or layers without changing the orientation of the reference layers (55, 58) concerned;
- and **in that** the storage layers (55, 58) are coupled rnagnetostatically across the layer (70) made from antiferromagnetic material separating said storage layers, so that the magnetizations of said layers are placed in an antiparallel configuration when the temperature in the magnetic tunnel junction concerned exceeds the blocking temperature of said layer (70) of antiferromagnetic material and in the absence of a magnetic field applied to said memory, or under the influence of a magnetic field of lower intensity than the magnetostatic coupling between said storage layers.

**2.** The thermally assisted magnetic write memory as claimed in claim 1, *characterized* **in that** the product Resistance x Area of one of the two tunnel barriers (54, 57) is substantially equal to half of the other.

**3.** The thermally assisted magnetic write memory as claimed in either of claims 1 and 2, *characterized* **in that** the means for varying the orientation of the magnetic field of the storage layers consist of a single conductive line (130), located above or below the magnetic memory point concerned.

**4.** The thermally assisted magnetic write memory as claimed in one of claims 1 to *3, characterized* **in that** the memory points (50) have an elliptical or circular cross section.

5. The thermally assisted magnetic write memory as claimed in one of claims 1 to *4, **characterized** in that* the storage layers are made from a material based on an alloy of Fe, Co, Ni (CoFe or NiFe), which can be doped with boron, in particular when the tunnel barriers are made from MgO.

6. The thermally assisted magnetic write memory as claimed in one of claims 1 to *5, **characterized** in that* the thicknesses of the storage layers are different.

7. The thermally assisted magnetic write memory as claimed in one of claims 1 to *6, **characterized** in that* the magnetization of each of the storage and reference layers is substantially parallel to the plane of said layers.

8. The thermally assisted magnetic write memory as claimed in one of claims 1 to *7, **characterized** in that* the antiferromagnetic layers (60, 64) pinning the reference layers (53, 56) are made from a material whereof the blocking temperature is higher than the blocking temperature of the antiferromagnetic layer (70) separating the two magnetic tunnel junctions (51, 52).

9. The thermally assisted magnetic write memory as claimed in claim 8, ***characterized** in that* the antiferromagnetic layers (60, 64) pinning the reference layers (53, 56) are made from a material whereof the blocking temperature is higher than 250°C, and are made in particular from PtMn.

10. The thermally assisted magnetic write memory as claimed in either of claim 8 and 9, ***characterized** in that* the blocking temperature of the antiferromagnetic layer (70) separating the two magnetic tunnel junctions (51, 52) is lower than 200°C, said layer being made on the basis of a manganese rich alloy, and in particular from IrMn or FeMn.

11. The thermally assisted magnetic write memory as claimed in one of claims 1 to 10, ***characterized** in that* each of the reference layers consists of a multilayer comprising two magnetic layers and an intermediate layer selected from a material that comprises ruthenium, the two magnetic layers located on either side of this intermediate layer being antiferromagnetically coupled by this said intermediate layer.

12. A method for effecting the writing of memory points of a magnetic memory consisting of memory points or memory cells (50) according to claim 1, ***characterized** in that* each write phase is accompanied by an increase in temperature of the memory point concerned by the sending of a current pulse into a conductive line or bit line associated with the memory point concerned, and **in that** the actual writing takes place in three phases:

  ■ heating of the memory point by circulating a current in the conductive line (bit line) and then through the tunnel junction concerned to raise the temperature above the blocking temperature of the antiferromagnetic layer (70) separating the two storage layers (55, 58);
  ■ transmission of a current pulse into a conductive line (digit line) (15), to obtain the alignment of the magnetizations of the storage layers (55, 58) parallel or antiparallel to the alignment of the magnetizations of the reference layers in contact with the tunnel barriers;
  ■ definition of the states of the memory point during cooling:

    - interruption of the heating current before the end of the current pulse in the digit line: definition of the states "00" and "11" according to the polarity of the current passing through the digit line;
    - or interruption of the heating current after the end of the current pulse in the digit line: creation of a magnetostatic coupling between the two storage layers (55, 58), causing the switching of the magnetization of one of said two layers to favor an antiparallel alignment of the magnetizations, and which, according to the polarity of the current in the digit line, defines the states "01" and "10".

13. A method for effecting the writing of memory points of a magnetic memory consisting of memory points or memory cells (50) according to claim 1, said memory points being integrated in a matrix architecture, in which each memory point is associated with a switching transistor (12) controlled by an addressing line (16) (word line) for ordering the opening or closing of the channel of said transistors, ***characterized** in that* the writing of the matrix is realised by column by opening the world line (16) in order to place all the transistors (12) of the column concerned in ON mode; then by sending a heating current into all the bit lines (14) to permit the writing of all the memory points of the column according to the method of claim 12.

14. The method for writing memory points of a magnetic memory as claimed in claim 13, ***characterized** in that* the magnetic field generated by the digit line (15) during the writing of the states "01" and "10" is decreased to a value lower than the magnetostatic coupling field between the two storage layers (55, 58) located on either side of the pinning layer (70) of antiferromagnetic material.

Art Antérieur

**Fig. 1**

Art Antérieur

**Fig. 2**

**Fig. 3**

AF (PtMn)

Barrière tunnel 2 (RA2)

AF (IrMn)

Barrière tunnel 1 (RA1)

AF (PtMn)

**Fig. 4**

Etat 00

AF (PtMn)

Barrière tunnel 2 (RA2)

AF (IrMn)

Barrière tunnel 1 (RA1)

AF (PtMn)

50

**Fig. 5a**

+

130

Etat 01

AF (PtMn)

Barrière tunnel 2 (RA2)

AF (IrMn)

Barrière tunnel 1 (RA1)

AF (PtMn)

50

**Fig. 5b**

130

Etat 11

AF (PtMn)

Barrière tunnel 2 (RA2)

AF (IrMn)

Barrière tunnel 1 (RA1)

AF (PtMn)

50

**Fig. 5c**

+

130

Etat 10

AF (PtMn)

Barrière tunnel 2 (RA2)

AF (IrMn)

Barrière tunnel1 (RA1)

AF (PtMn)

50

**Fig. 5d**

130

| Etats à Ecrire | << 00 >> | << 01 >> | << 10 >> | << 11 >> |
|---|---|---|---|---|
| Action | - Chauffage<br>- H+<br>- Refroidir avec H+ | - Chauffage<br>- H+<br>- Refroidir sans H+ | - Chauffage<br>- H-<br>- Refroidir sans H- | - Chauffage<br>- H-<br>- Refroidir avec H- |

**Fig. 6**

**Fig. 7A**

**Fig. 7B**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4949039 A
- US 5159513 A
- US 5343422 A
- US 5640343 A
- US 6021065 A
- US 5583725 A
- US 6385082 B
- US 6549906 B
- US 20050002230 A

**Littérature non-brevet citée dans la description**

- *Journal of Applied Physics,* 1997, vol. 81, 3758